Europäisches Patentamt

European Patent Office

Office européen des brevets

(19)

(11) **EP 0 396 019 B1**

(12) **EUROPÄISCHE PATENTSCHRIFT**

(45) Veröffentlichungstag und Bekanntmachung des Hinweises auf die Patenterteilung:
**10.01.1996 Patentblatt 1996/02**

(51) Int Cl.⁶: **G01R 33/64**, **H01J 49/38**

(21) Anmeldenummer: **90107951.7**

(22) Anmeldetag: **26.04.1990**

(54) **Ionen-Zyklotron-Resonanz-Spektrometer**

Ion cyclotron resonance spectrometer

Spectromètre ionique à résonance cyclotronique

(84) Benannte Vertragsstaaten:
**CH DE FR GB LI**

(30) Priorität: **05.05.1989 DE 3914838**

(43) Veröffentlichungstag der Anmeldung:
**07.11.1990 Patentblatt 1990/45**

(73) Patentinhaber: **Spectrospin AG**
**CH-8117 Fällanden (CH)**

(72) Erfinder:
• **Allemann, Martin (Dr.)**
**CH-8340 Hinwil (CH)**
• **Caravatti, Pablo (Dr.)**
**CH-8400 Winterthur (CH)**

(74) Vertreter: **KOHLER SCHMID + PARTNER**
**D-70565 Stuttgart (DE)**

(56) Entgegenhaltungen:
EP-A- 0 259 596          US-A- 3 535 512

• INTERNATIONAL JOURNAL OF MASS SPECTROMETRY AND ION PROCESSES. vol. 72, no. 1/2, Oktober 1986, AMSTERDAM NL Seiten 15 - 31; S.K. HUANG ET AL.: "Mass-dependent z-excitation of ions in cubic traps used in Ftms"

**Beschreibung**

Die Erfindung betrifft ein Verfahren zum Betrieb eines Ionen-Zyklotron-Resonanz (ICR)-Spektrometers, dessen Meßzelle mehrere bezüglich einer zur Feldrichtung eines homogenen Magnetfeldes parallelen Achse axialsymmetrisch angeordnete, als HF-Elektroden ausgebildete Seitenwände umfaßt, und dessen Meßzelle elektrisch isolierte Trapping-Elektroden aufweist, welche an den beiden axialen Enden der Meßzelle angeordnet sind, wobei an die Trapping-Elektroden Fangpotentiale mit der Polarität der zu untersuchenden Ionen angelegt werden können, um ein Austreten der Ionen aus der Meßzelle in Achsrichtung weitgehend zu verhindern.

Ein solches ICR-Verfahren ist durch den Artikel "Ionen-Cyclotronresonanz zur Untersuchung von Ion-Molekül-Reaktionen" von Lebert in messtechnik, 6 (1970) 109-115, bekannt. Es eignet sich speziell zur Massenanalyse geladener Teilchen. Die zu untersuchenden Ionen werden dabei entweder extern erzeugt und mit Hilfe einer Ionenoptik in die ICR-Meßzelle eingeschossen, oder mit Hilfe eines in die ICR-Zelle gerichteten Elektronenstrahles durch Stoßionisation der Restgasteilchen in der Zelle erzeugt. Parallel zur Längsachse der Zelle durchsetzen die Feldlinien eines homogenen Magnetfeldes $\vec{B}$ den Innenraum der Zelle. Dadurch wirkt auf die q-fach geladenen Teilchen mit der Geschwindigkeit $\vec{v}$ die Lorentzkraft

$$\vec{K} = q\vec{v} \times \vec{B}.$$

Diese Kraft behindert die Bewegung eines Ions parallel zu den magnetischen Feldlinien nicht. Besitzt das Ion der Masse m jedoch eine Geschwindigkeitskomponente $v_t$ senkrecht zum Magnetfeld, so wird es durch die Lorentzkraft auf eine Kreisbahn gezwungen, deren Radius r sich aus dem Gleichgewicht von Zentrifugalkraft und Lorentzkraft ergibt:

$$r = mv_t/qB.$$

Auf dieser Kreisbahn läuft das Ion mit der Zyklotronfrequenz

$$\omega = qB/m$$

um. Einer bestimmten Zyklotronfrequenz ω sind also Ionen gleicher Masse zugeordnet, sodaß eine Massenanalyse des Ionenschwarmes durch eine Frequenzanalyse erfolgen kann. Die Zyklotronresonanz der Ionen wird durch eine Resonanzanregung ihrer charakteristischen Bewegung im homogenen Magnetfeld durch ein senkrecht zum Magnetfeld angelegtes elektrisches Hochfrequenz (HF) - Feld hervorgerufen.

Ein Problem aller bisher bekannten ICR-Zellen mit kubischer, zylindrischer oder hyperbolischer Geometrie besteht darin, daß aufgrund endlicher elektrischer HF-Feldkomponenten in axialer Richtung die Ionen während der Anregungsphase durch das elektrische HF-Feld nicht nur, wie gewünscht, Energie radial zur Magnetfaldrichtung gewinnen, sondern auch in axialer Richtung beschleunigt werden. Da die Potentialbarriere in axialer Richtung nur ca. 1eV hoch ist, können die in axialer Richtung beschleunigten Ionen leicht aus der Zelle entweichen und gehen damit für das Experiment verloren. Diese Problematik ist bekannt und in der Literatur beschrieben (z.B. Kofel et al., Int. J. Mass Spectrom. Ion Processes 74 (1986) 1-12).

Eine theoretische Lösung böte eine in axialer Richtung unendlich ausgedehnte Zelle, da das elektrische HF-Feld in einer solchen Zelle keine Axialkomponenten besäße und somit die Ionen in axialer Richtung nicht auslenken würde. Versuche mit länglichen Zellen, bei denen die Abmessungen in axialer Richtung sehr viel größer waren als der Zellendurchmesser, haben jedoch zu unbefriedigenden Resultaten geführt, weil vermutlich der Aufenthaltsbereich der Ionen über den homogenen Bereich des in der Regel von einem Kryomagneten erzeugten Magnetfeldes hinausreichte. Die Folgen mußten dann verzerrte Linienformen und ein reduziertes Auflösungsvermögen des Spektrometers sein. Um also das eine Problem nicht durch ein anderes zu ersetzen, sollten die an die Zelle angelegten DC-Potentiale den Aufenthaltsbereich der Ionen auf den homogenen Bereich des Magnetfelds beschränken.

Aufgabe der vorliegenden Erfindung ist es daher, ein Verfahren zum Betrieb eines ICR-Spektrometers zu entwickeln, bei dessen Anwendung ein Entweichen der Ionen aus der Meßzelle in axialer Richtung signifikant reduziert wird.

Diese Aufgabe wird hinsichtlich des Verfahrens erfindungsgemäß dadurch gelöst, daß zur Minimierung der achsparallelen Komponenten des in der Meßzelle auf die Ionen wirkenden elektrischen HF-Feldes auf beiden Seiten der Meßzelle an mindestens eine Trapping-Elektrode zusätzliche elektrische HF-Signale angelegt werden.

Nach diesem Verfahren kann das auf die Ionen in der Meßzelle einwirkende elektrische HF-Feld so geformt werden, als wenn es von in axialer Richtung unendlich langen HF-Elektroden eingestrahlt würde. Dies rührt daher, daß die Randinhomogenitäten, die durch die endliche Länge der Meßzelle in Achsrichtung an den Enden der Zelle hervorgerufen werden, durch Oberlagerung mit den zusätzlichen, über die Trapping-Elektroden eingestrahlten elektrischen HF-Feldkomponenten ausgeglichen werden. Dabei ist es nicht erforderlich, die Grundform der Meßzelle nennenswert zu verändern.

Um eine feste Phasenbeziehung zwischen dem an die als HF-Senderelektroden wirkenden Seitenwände der Zelle und dem an die jeweils diesen Seitenwänden räumlich am nächsten liegenden Trapping-Elektroden angelegten HF-Signal herzustellen, wird in einer Ausführungsart des erfindungsgemäßen Verfahrens der Wert der Frequenz des an der jeweiligen Trapping-Elektrode angelegten HF-Signals als ganzzahliges Vielfaches des HF-Wertes an der entsprechenden Seitenwand gewählt.

Besonders einfach können bei einer weiteren Ausführungsart des Verfahrens die HF-Einrichtungen des ICR-Spektrometers gestaltet werden, wenn an die Trapping-Elekzroden dieselben HF-Signale wie an die Seitenwände angelegt werden. Damit entfallen zusätzliche Frequenz- und/oder Spannungsteilereinrichtungen, die sonst zwischen die HF-Generatoren für die HF-Impulse an den Seitenwänden und die Trapping-Elektroden geschaltet werden müßten. Dazu ist es allerdings notwendig, daß die Geometrie der Trapping-Elektroden an die Form der entsprachenden HF-beaufschlagten Seitenwände so angepaßt ist, daß in der Überlagerung der HF-Felder die axiale Komponente minimiert wird.

Liegt hingegen eine bestimmte, vielleicht weniger günstige Form der Trapping-Elektroden aus versuchstechnischen oder anderen Gründen bereits fest, so können nach einer weiteren Ausführungsart des erfindungsgemäßen Verfahrens durch Variation der Spannungsamplituden der an die Trapping-Elektroden angelegten HF-Impulse die axiale Komponenten des auf die Ionen in der Meßzelle einwirkenden HF-Feldes minimiert werden.

Das erfindungsgemäße Verfahren findet Anwendung sowohl bei ICR-Spektrometern mit externer Ionenerzeugung als auch bei ICR-Spektrometern, bei denen die Ionen in der Meßzelle (z.B. durch Elektronenstoß) erzeugt werden. Ebenso ist bei Driftkammern die Minimierung der axialen Komponente des HF-Feldes durch das erfindungsgemäße Verfahren äußerst vorteilhaft, weil dadurch störende Einflüsse des HF-Feldes auf die zu untersuchende Reaktionsdynamik der Teilchen parallel zu der im allgemeinen mit der Meßzellenachse zusammenfallenden Driftachse weitgehend vermieden werden können. Das gleiche gilt auch für die Anwendung des erfindungsgemäßen Verfahrens in Doppel- oder Mehrfachresonanz-Apparaturen, wie aus der US-PS 3,511,986 oder dem oben erwähnten Artikel von K.-H. Lebert bekannt, sowie für die Anwendung in der Fourier-(Transformierten)-Massenspektrometrie (FTMS), wie z.B. von Cody et al., Anal. Chem., 54 (1982) 2225-2228, oder von Settine et al., European Spectroscopy News, 58 (1985) 16-18, beschrieben.

In den Rahmen der Erfindung fällt auch ein ICR-Spektrometer, dessen Meßzelle mehrere bezüglich einer zur Feldrichtung eines homogenen Magnetfeldes parallelen Achse axialymmetrisch angeordnete, als mit einem HF-Generator verbundene HF-Sendeelektroden bzw.als HF-Empfangselektroden ausgebildete Seitenwände umfaßt, und dessen Meßzelle elektrisch isolierte Trapping- Elektroden aufweist, welche an den beiden axialen Enden der Meßzelle angeordnet sind, wobei an die Trapping-Elektroden mittels einer Gleichspannungsquelle Fangpotentiale mit der Polarität der zu untersuchenden Ionen angelegt werden können, um ein Austreten der Ionen aus der Meßzelle in Achsrichtung weitgehend zu verhindern, das dadurch gekennzeichnet ist, daß mittels des HF-Generators an beiden axialen Enden der Meßzelle jeweils an mindestens eine Trapping-Elektrode zusätzliche elektrische HF-Signale angelegt werden können, wobei die Trapping-Elektroden in solchen Gestaltungen realisiert sind, daß das Anlegen der zusätzlichen HF-Signale an die Trapping-Elektroden die achsparallele Komponente des in der Meßzelle auf die Ionen wirkenden elektrischen HF-Feldes minimiert.

Dabei kann die Meßzelle eine beliebige axialsymmetrische Form, z.B. die Form eines Zylinders, eines Kubus oder eines Quaders besitzen. Je nach den speziellen Erfordernissen des Experimentes kann die Meßzelle des erfindungsgemäßen ICR-Spektrometers aber auch in Form einer Kugel, eines Doppelkegels oder eines Penningkäfigs mit rotationshyperboloiden Wandflächen ausgebildet sein.

Bei einer speziellen Ausführungsform der Erfindung werden die Seitenwände der Meßzelle von vier elektrisch voneinander isolierten azimutalen Mantelabschnitten eines Kreiszylinders gebildet, von denen jeweils zwei einander gegenüberliegende Seitenwände als HF-Senderelektroden und die beiden anderen Seitenwände als HF-Empfängerelektroden betrieben werden können.

Bei einer Ausgestaltung des erfindungsgemäßen ICR-Spektrometers wird die kreiszylinderförmige Meßzelle an ihren Stirnseiten von jeweils einer aus drei Trapping-Elektroden zusammengesetzten Kreisscheibe mit dem Radius des von den Seitenwänden gebildeten Kreiszylinders abgedeckt, wobei die äußeren Ränder der inneren Trapping-Elektroden den Kanten der Seitenwände ohne HF-Anschluß, die äußeren Ränder der beiden äußeren Trapping-Elektroden den Kanten der Seitenwände mit HF-Anschluß gegenüberliegen, und die äußeren Trapping-Elektroden zusätzlich zu dem auch an den inneren Trapping-Elektroden anliegenden Fangpotential mit einem HF-Signal beaufschlagt werden können.

Ein besonders günstiger HF-Feldlinienverlauf im Hinblick auf eine Minimierung der axialen Komponenten des HF-Feldes in der Meßzelle wird durch eine weitere Ausgestaltung erzielt, bei der die inneren und äußeren Ränder der HF-beaufschlagten äußeren Trapping-Elektroden Kreisbögen gleicher Bogenlängen sind. Eine weitere Verbesserung wird dadurch erreicht, daß die Konturen der inneren Ränder der Trapping-Elektroden dem tatsächlichen Verlauf von HF-Äquipotentiallinien, insbesondere den Linien für + U/2 und - U/2, deren Verlauf den Ort des halben maximalen Betrages des von den Seitenwänden eingestrahlten elektrischen HF-Feldes markieren, folgen.

Bei einer anderen Ausführungsform des ICR-Spektrometers schließt sich an den von den Seitenwänden gebildeten Zylinder in axialer Richtung beidseits jeweils ein weiterer Zylinder von gleichem Querschnitt wie der erstere an, dessen azimutale Mantelabschnitte jeweils von zwei Paaren einander gegenüberliegender Trapping-Elektroden gebildet werden, wobei sich die Ränder der Trapping-Elektroden an die Kanten der Seitenwände anschließen und etwa die gleiche Länge besitzen wie diese, und wobei dasjenige Paar von Trapping-Elektroden, das, in axialer Richtung gesehen, den HF-beaufschlagten Seitenwänden der Meßzelle gegenüberliegt, zusätzlich zu dem auch an dem anderen Paar von Trapping-Elektroden anliegenden Fangpotential mit einem HF-Signal beaufschlagt werden kann.

Hierdurch wird erreicht, daß das elektrische HF-Feld an den Rändern der Meßzelle nicht wie beim herkömmlichen Abschluß der Zelle mit ebenen, nicht HF-beaufschlagten Trapping-Elektroden abrupt abgebrochen wird, was zu unerwünschten Feldverzerrungen und zur Entstehung der schädlichen Axialkomponenten der HF-Feldlinien führt, sondern daß das HF-Feld in der Zelle so homogen ist, wie es in einer Zelle mit unendlicher axialer Ausdehnung theoretisch vorliegen würde und ausschließlich radiale Feldkomponenten aufweist.

Bei einer bevorzugten Gestaltung sind die aus den Seitenwänden der Meßzelle und den Trapping-Elektroden aufgebauten drei Zylinder einander gleich, was die Herstellung und die Handhabung der Vorrichtung besonders vereinfacht.

Bei einer weiteren Ausführungsform des erfindungsgemäßen ICR-Spektrometers bestehen die Trapping-Elektroden aus mehreren parallelen Streifen, die zusammen zwei Scheiben bilden, mit denen die Meßzelle beidseits abgeschlossen wird. Um den HF-Feldverlauf in der Meßzelle im Hinblick auf eine Minimierung der Inhomogenitäten und damit der schädlichen Axialkomponenten der HF-Feldlinien feindosiert zu beeinflussen, werden die Trapping-Elektroden an die HF-Spannungsquelle kapazitiv so angekoppelt, daß die an den Trapping-Elektroden anliegende HF-Spannung stufenweise von der einen Polarität, die an der als HF-Senderelektrode wirkenden, der entsprechenden äußeren Trapping-Elektrode benachbarten Seitenwand der Meßzelle anliegt, in die entgegengesetzte Polarität auf der anderen Seite der Zelle übergeführt wird.

In der theoretisch günstigsten Ausgestaltung der letztgenannten Ausführungsform sind die Ränder der die Trapping-Elektroden bildenden Streifen nicht parallel, sondern ihre Konturen folgen dem tatsächlichen Verlauf der HF-Äquipotentiallinien.

Denkt an sich die Unterteilung der Trapping-Elektroden in eine immer größere Anzahl immer schmalerer Streifen fortgesetzt, was ja zu einer immer feineren Abstufung der HF-Anpassungspotentiale an den einzelnen Trapping-Elektroden führen würde, so gelangt man im Grenzfall zu einem kontinuierlichen Übergang von der einen HF-Polarität zur entgegengesetzten. Dieses wird in einer weiteren Ausführungsform der Erfindung durch die Verwendung von hochohmigen Trapping-Elektroden verwirklicht, die auf beiden Seiten jeweils an die als HF-Sender-Elektrode betriebene, benachbarte Seitenwand der Zelle kapazitiv angekoppelt sind. Typische Werte des elektrischen Widerstandes der Trapping-Elektroden von einer Seite zur anderen liegen etwa zwischen 1 und 100 kΩ. Bei speziellen Ausführungsformen können die Trapping-Elektroden allerdings auch als Abschlußwiderstände für den HF-Sender dienen und einen Widerstandswert um 50 Ω aufweisen.

Bei einer Ausführungsform der Erfindung bestehen die hochohmigen Trapping-Elektroden aus einer auf der dem Innenraum der Meßzelle zugewandten Seite eines nichtleitenden Substrates aufgebrachten hochohmigen Leiterschicht. Insbesondere kann das Substrat aus Keramikmaterial, z.B. $TiO_2$, und die Leiterschicht aus darauf aufgedampftem Metall, z.B. Ag oder Au, bestehen.

Bei einer bevorzugten Ausführungsform des erfindungsgemäßen ICR-Spektrometers bestehen die Trapping-Elektroden aus einem polymeren halogenierten Polyolefin, insbesondere aus Polytetrafluoräthylen (PTFE), wie z.B. Teflon, und weisen einen hohen Kohlenstoffanteil, insbesondere zwischen 10 und 30 Gewichtsprozent, auf. Diese Trapping-Elektroden sind besonders einfach und billig herzustellen.

Bei einer weiteren Ausführungsform enthalten die Trapping-Elektroden Halbleiter-Materialien wie z.B. Si, Ge oder GaAs.

Die Erfindung wird im folgenden anhand der in der Zeichnung dargestellten Ausführungsbeispiele näher beschrieben und erläutert.

Fig. 1a      eine räumliche Darstellung einer ICR-Zelle nach der Erfindung,

Fig. 1b      eine Draufsicht in axialer Richtung auf die ICR-Zelle von Fig. 1a mit schematisch dargestellter elektrischer Verschaltung,

Fig. 2      eine räumliche Darstellung einer Ausführungsform einer erfindungsgemäßen ICR-Zelle mit zylinderförmigen Trapping-Elektroden,

Fig. 3a      eine räumliche Darstellung einer erfindungsgemäßen ICR-Zelle mit streifenförmigen Trapping-Elektroden

Fig. 3b      eine Draufsicht in axialer Richtung auf die ICR-Zelle aus Fig. 3a mit elektrischer Verschaltung

Fig. 3c      eine Draufsicht in axialer Richtung auf eine erfindungsgemäße ICR-Zelle mit Kreiszylindergeometrie und streifenförmigen Trapping-Elektroden mit schematisch dargestellter elektrischer Verschaltung,

Fig. 4      einen schematischen Längsschnitt durch eine erfindungsgemäße ICR-Zelle mit hochohmig beschichteten Trapping-Elektroden mit schematisch dargestellter elektrischer Verschaltung,

Fig. 5a      den Verlauf der Äquipotentiallinien des elektrischen HF-Feldes einer ICR-Zelle mit quadratischem Querschnitt in einer zur Zellachse senkrechten Schnittebene, wobei sich benachbarte Äquipotentiallinien um jeweils 5% des Betrages (U) der an den Seitenwänden anliegenden HF-Spannung unterscheiden,

Fig. 5b den Verlauf der Äquipotentiallinien einer ICR-Zelle mit zylindersymmetrischem Querschnitt in einer zur Zellachse senkrechten Schnittebene.

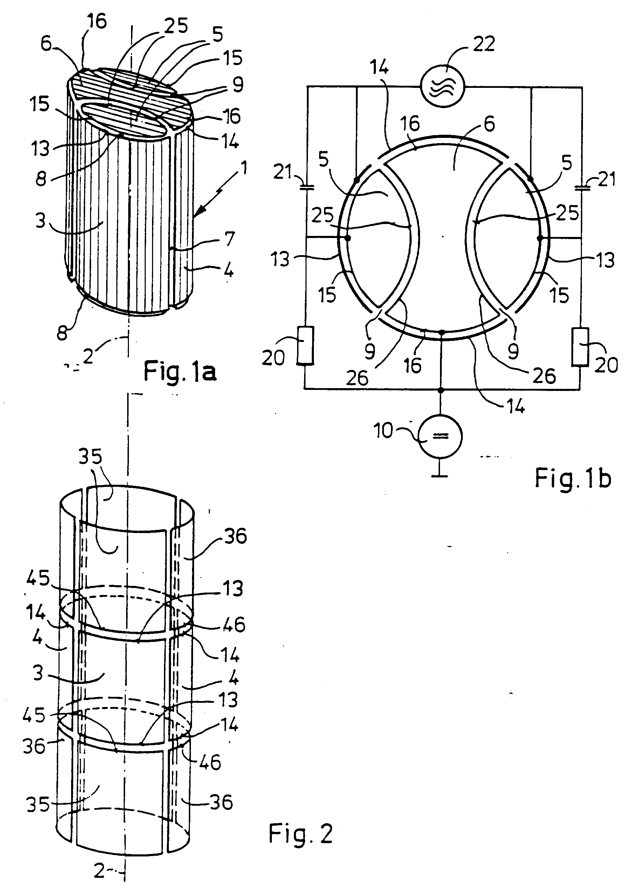

Die in Fig. 1a dargestellte Meßzelle 1 eines Ionen-Zyklotron-Resonanz-Spektrometers umfaßt zwei Paare von sich jeweils gegenüberliegenden, als HF-Elektroden ausgebildeten Seitenwänden 3 bzw. 4, sowie, entlang der zentralen Achse 2 gesehen, beiderseits der Zelle angeordnete elektrisch isolierte Trapping-Elektroden 5 und 6. Die Seitenwände 3, 4 sind untereinander durch Spalte 7 und von den Trapping-Elektroden 5, 6 durch Spalte 8 getrennt. Die äußeren Trapping-Elektroden 5 sind von den inneren Trapping-Elektroden 6 durch Spalte 9 getrennt. Den Kanten 13 der Seitenwände 3 sind die Ränder 15 der äußeren Trapping-Elektroden 5 benachbart; den Kanten 14 der Seitenwände 4 sind die Ränder 16 der inneren Trapping-Elektroden 6 benachbart.

Fig. 1b zeigt die elektrische Verschaltung der Meßzelle 1: Die gegenüberliegenden Seitenwände 3 sind mit je einem der beiden Polen eines HF-Generators 22 verbunden und wirken daher als Sender-Elektroden. Die elektrische Verschaltung der als Empfänger-Elektroden wirkenden Seitenwände 4 ist nicht dargestellt. Über Kapazitäten 21 sind die äußeren Trapping-Elektroden 5 ebenfalls an den gleichen Pol des HF-Generators 22 angekoppelt wie die ihnen jeweils zunächst liegende Seitenwand 3. Außerdem werden die äußeren Trapping-Elektroden 5 über Widerstände 20 und die inneren Trapping-Elektroden 6 direkt mit Gleichspannung aus der Gleichspannungsquelle 10 versorgt.

Die ICR-Zelle befindet sich während des Betriebs üblicherweise in einem hohen oder ultrahohen Vakuum. Ein Meßzyklus beginnt damit, daß an die Trapping-Elektroden 5, 6 ein elektrisches Potential angelegt wird, das dem der zu untersuchenden Ionen entgegengesetzt ist, so daß alle innerhalb der Zelle befindlichen Ionen abgesaugt werden. Anschließend werden die Ionen, die untersucht werden sollen, entweder mit Hilfe einer nicht dargestellten Ionenoptik von außerhalb der Zelle, z. B. durch geeignete Bohrungen längs der Achse 2, in die Meßzelle eingeschossen oder innerhalb der Meßzelle, z. B. durch Elektronen-Stoßionisation von Restgasteilchen, erzeugt. Ein homogenes Magnetfeld B, dessen Feldlinien parallel zur Achse 2 verlaufen, übt auf alle Ionen mit Geschwindigkeitskomponenten senkrecht zur Achse 2 eine Lorentzkraft aus, welche die Ionen auf Kreisbahnen senkrecht zu den Magnetfeldlinien zwingt. Durch Einstrahlen eines geeigneten elektrischen Hochfrequenz(HF)-Signales über die Seitenwände 3 können die zu untersuchenden Ionen senkrecht zu den magnetischen Feldlinien ausgelenkt und zu einer für ihre Masse charakteristischen Bewegung um die Magnetfeldlinien, der sogenannten Zyklotron-Resonanz, angeregt werden. Die auf diese Weise kohärent angeregten, in der Zelle umlaufenden Ionen erzeugen auf den Seitenwänden 4 durch induzierte Ladungen hochfrequente Signale, die mit geeigneten meßtechnischen Mitteln abgegriffen, verstärkt und analysiert werden können.

Die Bewegung der Ionen parallel zur Achse 2 wird durch das homogene Magnetfeld nicht behindert. Um Ionen mit Geschwindigkeitskomponenten parallel zur Achse 2 am Austritt aus der Zelle in axialer Richtung zu hindern, wird an die Trapping-Elektroden 5, 6 ein elektrostatisches Fangpotential aus der Gleichspannungsquelle 10 mit der Polarität der zu untersuchenden Ionen angelegt. Die Höhe der Potentialbarriere in axialer Richtung kann allerdings 1 eV nicht wesentlich übersteigen, weil sonst das in den Meßraum hineingreifende elektrostatische Feld, insbesondere seine Komponenten quer zur Achse 2, die Ionenbewegungen zu sehr stören würde.

Während das elektrische HF-Feld, das von den Seitenwänden 3 eingestrahlt wird, in den mittleren Bereichen der Meßzelle 1 verschwindend geringe Komponenten in Richtung der Achse 2 besitzt, nehmen die axialen HF-Feldkomponenten aufgrund von Feldlinienverkrümmungen in der Nähe der Trapping-Elektroden stark zu, was für Ionen, die in diese Regionen gelangen, eine Beschleunigung auch in axialer Richtung zur Folge hat. Viele dieser axial beschleunigten Ionen durchbrechen die Potentialbarriere des elektrostatischen Feldes, fallen auf die Trapping-Platten und gehen dem Meßprozeß verloren.

Durch Einstrahlen des elektrischen HF-Feldes über die Trapping-Elektroden 5 können die Randinhomogenitäten des von den Seitenwänden 3 eingestrahlten elektrischen HF-Feldes wesentlich abgeschwächt, die Axialkomponenten des im Innenraum der Meßzelle 1 auf die Ionen wirkenden elektrischen HF-Feldes minimiert und dadurch die Verluste durch in axialer Richtung aus der Zelle austretende Ionen entscheidend verkleinert worden. Dazu ist es notwendig, daß die Frequenz des zusätzlich von den Trapping-Elektroden 5 eingestrahlten HF-Signales einen Wert hat, der einem ganzzahligen Vielfachen der Frequenz des an der den Trapping-Elektroden 5 räumlich jeweils nächstliegenden Seitenwänden 3 angelegten HF-Signales entspricht. Insbesondere können die Frequenzen auch gleich sein. Außerdem ist es möglich, durch entsprechendes Einstellen der Amplituden der von den Trapping-Elektroden 5 eingestrahlten HF-Impulse die axialen Komponenten des gesamten elektrischen HF-Feldes innerhalb der Meßzelle 1 zu minimieren. Die spezielle Form der Trapping-Elektroden 5, 6 in den Fig. 1a und 1b, bei denen die äußeren Ränder 15 und die inneren Ränder 25 Kreisbögen gleicher Bogenlänge sind, wobei diese Bogenlänge im wesentlichen mit jener der Kanten 13 zusammenfällt, ermöglicht eine Minimierung der axialen HF-Feldkomponenten bereits durch Anlegen von HF-Signalen an die Trapping-Elektroden 5, die die gleiche Frequenz und die gleiche Amplitude aufweisen, wie die an die Seitenwände 3 angelegten HF-Signale.Dadurch können zusätzliche Frequenz- und/oder Spannungsteiler-Einrichtungen entfallen.

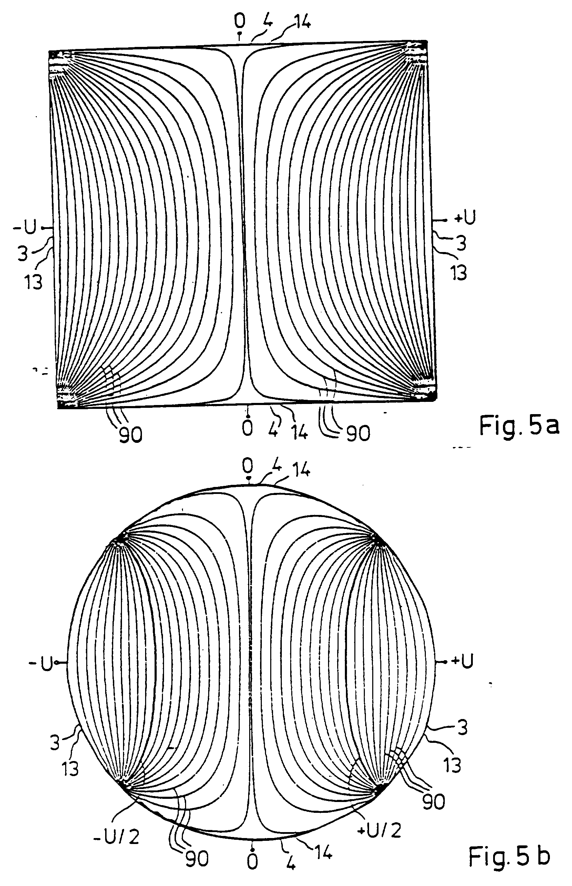

Eine weitere Verbesserung wird dadurch erzielt, daß die Konturen der inneren Ränder 25 der äußeren Trapping-Elektroden 5 und der inneren Ränder 26 der inneren Trapping-Elektrode 6 dem gemessenen oder berechneten Verlauf einer der HF-Äquipotentiallinien, wie sie in Fig. 5b dargestellt sind, folgen. Insbesondere können hierzu die Linien für + U/2 und - U/2 gewählt werden, die in dem in Fig. 5b gezeigten Beispiel für ein an den Seitenwänden 3 eingestrahltes HF-Feld mit den Spannungsamplituden ± U besonders hervorgehoben sind.

Fig. 2 zeigt eine aus drei Zylindern mit gemeinsamer Achse 2 aufgebaute Meßzelle 1. Der mittlere Zylinder besteht aus zwei Paaren gegenüberliegender Seitenwände 3 bzw. 4, die das eigentliche Meßvolumen eingrenzen. Die Seitenwände 3 wirken wieder als HF-Senderelektroden, während die Seitenwände 4 als HF-Empfängerelektroden benutzt werden. Die beidseitig an diesen mittleren Zylinder anschließenden Zylinder werden von Paaren gegenüberliegender Trapping-Elektroden 35 bzw. 36 gebildet. Dabei liegen die Ränder 45 der zusätzlich zu den angelegten Fangpotentialen mit entsprechenden HF-Impulsen beaufschlagbaren Elektroden 35 gegenüber den Kanten 13 der Seitenwände 3, während die Ränder 46 der lediglich mit dem Fangpotential beaufschlagten Trapping-Elektroden 36 den Kanten 14 der Seitenwände 4 gegenüberliegen. Werden in dieser Anordnung an die Trapping-Elektroden 35 genau die gleichen HF-Impulse wie an die Seitenwände 3 angelegt, werden die Randinhomogenitäten des elektrischen HF-Feldes im mittleren Zylinder vollständig beseitigt. Die HF-Feldverteilung im Bereich der Kanten 13, 14 gleicht derjenigen, die in einer axial unendlich ausgedehnten Zelle herrschen würde. Besonders vorteilhaft für die Herstellung dieser Ausführungsform einer ICR-Zelle ist es, wenn alle drei Zylinder gleich groß und aus gleichem Material gefertigt werden. Im Prinzip können dann sämtliche Elektroden 3, 4, 35 und 36 austauschbar sein.

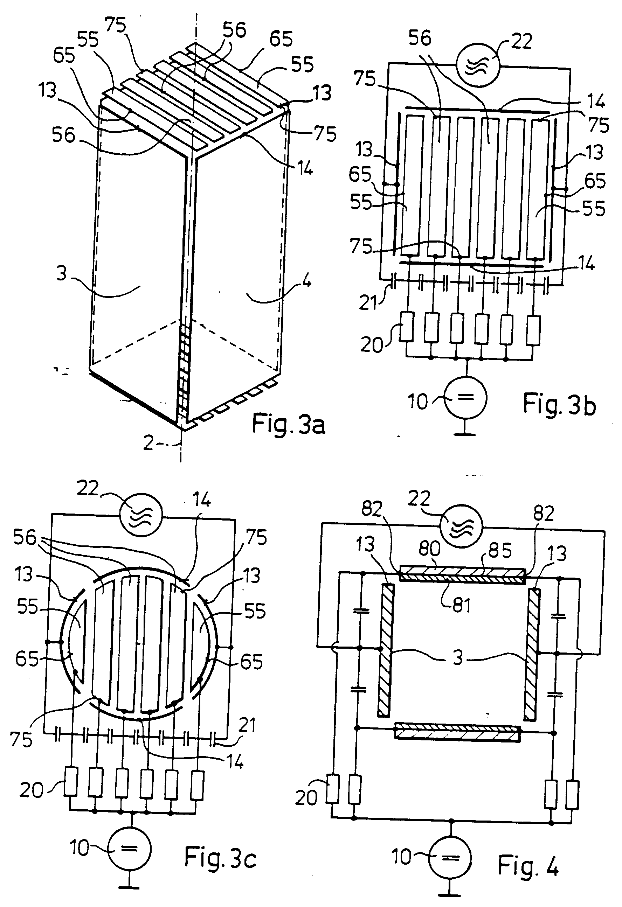

Die Meßzelle 1 in Fig. 3a hat die Form eines länglichen Quaders mit quadratischer Grund- und Deckfläche, die jeweils aus einer ebenen Anordung streifenförmiger Trapping-Elektroden 55 bzw. 56 gebildet werden. Dabei liegen die Längskanten 65 der äußeren Trapping-Elektroden 55 jeweils den Kanten 13 der HF-beaufschlagten Seitenwände 3 gegenüber, während die Querkanten 75 sowohl der äußeren Trapping-Elektroden 55 als auch der inneren Trapping-Elektroden 56 den Kanten 14 der als Empfänger-Elektroden betriebenen Seitenwände 4 gegenüberliegen. Die elektrische Verschaltung der Meßzelle 1 aus Fig. 3a ist in Fig. 3b dargestellt. Die inneren Trapping-Elektroden 56 sind über die Kapazitäten 21 jeweils mit ihren Nachbarn verbunden, während die beiden äußeren Trapping-Elektroden 55 kapazitiv an die jeweils benachbarte, HF-beaufschlagte Seitenwand 3 angekoppelt sind. Durch die Anordnung wird die an den Trapping-Elektroden anliegende HF-Spannung stufenweise von der einen Polarität des HF-Generators 22 in die andere übergeführt. Dadurch kann der HF-Feldverlauf in der Meßzelle im Hinblick auf eine Minimierung der Inhomogenitäten in den Randbereichen, insbesondere der schädlichen Axialkomponenten der HF-Feldlinien, feindosiert beeinflußt werden. Die der Fig. 3b entsprechende Fig. 3c zeigt eine analoge Anordnung in Zylindersymmetrie. Die Meßzelle 1 kann auch in Form eines prismatischen Körpers oder überhaupt in jeder beliebigen axialsymmetrischen Anordnung ausgeführt sein.

In der theoretisch günstigsten Ausgestaltung sind die Ränder der die Trapping-Elektroden 55, 56 bildenden Streifen nicht parallel, sondern ihre Konturen folgen dem tatsächlichen Verlauf der HF-Äquipotentiallinien. Dieser ist in Fig. 5a für eine ICR-Zelle mit quadratischem Querschnitt, in Fig. 5b für eine Zelle mit zylindersymmetrischem Querschnitt gezeigt. Benachbarte Äquipotentiallinien 90 unterscheiden sich in ihrem Potential jeweils um 5% der an den Seitenwänden 3 anliegenden HF-Spannungsamplituden vom Betrag U. In Fig. 5b sind die beiden Äquipotentiallinien besonders hervorgehoben, auf denen das Potential den halben Betrag der Spannungsamplituden an den Wänden besitzt.

Stellt man sich die Unterteilung der Trapping-Elektroden in eine immer größere Anzahl immer schmalerer Streifen fortgesetzt vor, was zu immer feineren Abstufungen der HF-Anpassungspotentiale an den einzelnen Trapping-Elektroden führen würde, so gelangt man im Grenzfall zu einem kontinuierlichen Übergang von der einen HF-Polarität zur entgegengesetzten. Dies ist in der in Fig. 4 gezeigten Ausführungsform verwirklicht. Die ICR-Zelle kommt hier mit lediglich zwei Trapping-Elektroden 85 aus, die an den Stirnseiten der Meßzelle 1 angeordnet sind. Den Kanten 13 der HF-beaufschlagten Seitenwände 3 unmittelbar benachbart liegen die Kanten 82, über welche die Trapping-Elektroden 85 kapazitiv an den jeweiligen Pol des HF-Generators 22 angekoppelt sind. Die Trapping-Elektroden 85 in Fig. 4 bestehen aus einer auf ein Substrat 80 aufgedampften, hochohmigen Leiterschicht 81, deren Widerstand zwischen zwei gegenüberliegenden Rändern 82 typischerweise 1 - 100 kΩ beträgt. Bei speziellen Ausführungsformen können die Trapping-Elektroden 85 allerdings auch als Abschlußwiderstände für den HF-Sender dienen und einen Widerstandswert um 50 Ω aufweisen. Insbesondere kann das Substrat aus Keramikmaterial, z. B. $TiO_2$, und die Leiterschicht aus darauf aufgedampftem Metall, z. B. Ag oder Au bestehen. Die Trapping-Elektroden 85 können aber auch aus einem polymeren halogenierten Polyolefin, insbesondere auch Polytetrafluoräthylen (PTFE), wie z. B. Teflon, mit einem hohen Kohlenstoffanteil von zwischen 10 und 30 Gew.-% bestehen. Die Trapping-Elektroden 85 sind dann besonders einfach und billig herzustellen. Eine weitere Möglichkeit ist der Einsatz von Halbleiter-Materialien wie z.B. Si, Ge oder GaAs zur Herstellung der Trapping-Elektroden 85.

## Patentansprüche

1. Verfahren zum Betrieb eines Ionen-Zyklotron-Resonanz-Spektrometers, dessen Meßzelle (1) mehrere bezüglich einer zur Feldrichtung eines homogenen Magnetfeldes parallelen Achse (2) axialsymmetrisch angeordnete, als HF-Elektroden ausgebildete Seitenwände (3,4) umfaßt, und dessen Meßzelle (1) elektrisch isolierte Trapping-Elektroden (5,6,35,36,55,56,85) aufweist, welche an den beiden axialen Enden der Meßzelle (1) angeordnet sind, wobei an die Trapping-Elektroden (5,6,35,36,55,56,85) Fangpotentiale mit der Polarität der zu untersuchenden Ionen angelegt werden können, um ein Austreten der Ionen aus der Meßzelle (1) in Achsrichtung weitgehend zu verhindern, dadurch gekennzeichnet, daß zur Minimierung der achsparallelen Komponente des in der Meßzelle (1) auf die Ionen wirkenden elektrischen HF-Feldes an beiden axialen Enden der Meßzelle (1) an jeweils mindestens eine Trapping-Elektrode (5,35,55,56,85) zusätzliche elektrische HF-Signale angelegt werden.

2. Verfahren nach Anspruch 1, dadurch gekennzeichnet, daß die Frequenz des an die Trapping-Elektroden (5,35,55,56,85) angelegten HF-Signals einen Wert hat, der gleich oder ein ganzzahliges Vielfaches der Frequenz des an den den Trapping-Elektroden (5,35,55,56,85) räumlich jeweils nächstliegenden Seitenwänden (3) angelegten HF-Signales ist.

3. Verfahren nach Anspruch 1 oder 2, dadurch gekennzeichnet, daß die Amplituden der an die Trapping-Elektroden (5,35,55,56,85) angelegten HF-Impulse unabhängig von den Amplituden der an die Seitenwände (3) angelegten HF-Impulse einstellbar sind.

4. Verfahren nach einem der vorhergehenden Ansprüche, dadurch gekennzeichnet, daß die Meßzelle (1) als Driftkammer betrieben wird.

5. Verfahren nach einem der vorhergehenden Ansprüche, dadurch gekennzeichnet, daß das Spektrometer als Doppel- oder Mehrfachresonanzanordnung betrieben wird.

6. Verfahren nach einem der vorhergehenden Ansprüche, dadurch gekennzeichnet, daß das Spektrometer als Fourier-Massenspektrometer betrieben wird.

7. Ionen-Zyklotron-Resonanz (ICR)-Spektrometer, dessen Meßzelle (1) mehrere bezüglich einer zur Feldrichtung eines homogenen Magnetfeldes parallelen Achse (2) axialsymmetrisch angeordnete, als mit einem HF-Generator (22) verbundene HF-Sendeelektroden (3) bzw. als HF-Empfangselektroden (4) ausgebildete Seitenwände (3,4) umfaßt, und dessen Meßzelle (1) elektrisch isolierte Trapping-Elektroden (5,6,35,36,55,56,85) aufweist, welche an den beiden axialen Enden der Meßzelle (1) angeordnet sind, wobei an die Trapping-Elektroden (5,6,35,36,55,56,85) mittels einer Gleichspannungsquelle (10) Fangpotentiale mit der Polarität der zu untersuchenden Ionen angelegt werden können, um ein Austreten der Ionen aus der Meßzelle (1) in Achsrichtung weitgehend zu verhindern, dadurch gekennzeichnet, daß mittels des HF-Generators (22) an beiden axialen Enden der Meßzelle (1) jeweils an mindestens eine Trapping-Elektrode (5, 35, 55, 56, 85) zusätzliche elektrische HF-Signale angelegt werden können, wobei die Trapping-Elektroden in solchen Gestaltungen realisiert sind, daß das Anlegen der zusätzlichen HF-Signale an die Trapping-Elektroden die achsparallele Komponente des in der Meßzelle (1) auf die Ionen wirkenden elektrischen HF-Feldes minimiert.

8. ICR-Spektrometer nach Anspruch 7, dadurch gekennzeichnet, daß die Meßzelle (1) die Form eines Zylinders, insbesondere eines Kreiszylinders, eines Quaders oder eines Würfels besitzt, daß die Trapping-Elektroden (5, 6, 55, 56, 85) die Meßzelle (1) an beiden Enden in axialer Richtung abschließen.

9. ICR-Spektrometer nach Anspruch 7 oder 8, dadurch gekennzeichnet, daß die Seitenwände (3,4) der Meßzelle (1) durch vier elektrisch voneinander isolierte Mantelabschnitte eines Kreiszylinders gebildet werden, wobei zwei gegenüberliegende Seitenwände (3) als HF-Senderelektroden und die beiden anderen Seitenwände (4) als HF-Empfängerelektroden betrieben werden können.

10. ICR-Spektrometer nach Anspruch 9, dadurch gekennzeichnet, daß die Meßzelle (1) an ihren Stirnseiten von jeweils einer Kreisscheibe mit dem Radius des von den Seitenwänden (3,4) gebildeten Kreiszylinders bestehend aus jeweils drei Trapping-Elektroden (5,6) abgedeckt wird, wobei die äußeren Ränder (16) der inneren Trapping-Elektroden (6) den Kanten (14) der Seitenwände (4) ohne HF-Anschluß, die äußeren Ränder (15) der beiden äußeren Trapping-Elektroden (5) den Kanten (13) der Seitenwände (3) mit HF-Anschluß gegenüberliegen, und die äußeren Trapping-Elektroden (5) zusätzlich zu dem auch an den inneren Trapping-Elektroden (6) anliegenden Fangpotential noch mit einem HF-Signal beaufschlagt werden können.

**11.** ICR-Spektrometer nach Anspruch 10, dadurch gekennzeichnet, daß die äußeren Ränder (15) und die inneren Ränder (25) der äußeren Trapping-Elektroden (5) Kreisbögen gleicher Bogenlängen sind.

**12.** ICR-Spektrometer nach Anspruch 10, dadurch gekennzeichnet, daß die äußeren Ränder (15) der äußeren Trapping-Elektroden (5) und die äußeren Ränder (16) der inneren Trapping-Elektrode (6) Kreisbögen gleicher Bogenlänge sind, während die Konturen der inneren Ränder (25) der äußeren Trapping-Elektroden (5) und der inneren Ränder (26) der inneren Trapping-Elektrode (6) dem berechneten Verlauf einer HF-Äquipotentiallinie (90) angenähert sind, insbesondere der jeweiligen Äquipotentiallinie der halben positiven und der halben negativen Amplitude des an die Senderelektroden angelegten HF-Feldes.

**13.** ICR-Spektrometer nach Anspruch 7, dadurch gekennzeichnet, daß sich an einen durch die Seitenwände (3,4) gebildeten Zylinder in axialer Richtung beidseits jeweils ein weiterer Zylinder von gleichem Querschnitt wie der erstere anschließt, dessen azimutale Mantelabschnitte jeweils von zwei Paaren einander gegenüberliegender Trapping-Elektroden (35 bzw. 36) gebildet werden, wobei sich die Ränder (45, 46) der Trapping-Elektroden (35, 36) an die Kanten (13, 14) der Seitenwände (3, 4) anschließen und etwa die gleiche Länge besitzen wie diese und wobei dasjenige Paar (35) von Trapping-Elektroden, das, in axialer Richtung gesehen, den HF-beaufschlagten Seitenwänden (3) der Meßzelle (1) gegenüberliegt, zusätzlich zu dem auch an dem anderen Paar von Trapping-Elektroden (36) anliegenden Fangpotential mit einem HF-Signal beaufschlagt werden kann.

**14.** ICR-Spektrometer nach Anspruch 8 oder 9, dadurch gekennzeichnet, daß die Meßzelle (1) beidseits von jeweils einer Scheibe abgedeckt wird, deren Umfangskontur einen Querschnitt berandet, der dem durch die Seitenwände (3, 4) gebildeten Querschnitt der Meßzelle (1) senkrecht zur Achse (2) entspricht, wobei die Scheibe aus einer Anzahl parallel angeordneter, streifenförmiger Trapping-Elektroden (55, 56) aufgebaut ist, deren äußere Trapping-Elektroden (55) mit jeweils einer ihrer Längskanten (65) an die jeweilige Kante (13) einer Seitenwand (3) der Meßzelle (1) anschließen, während die Querkanten (75) an die Kanten (14) der Seitenwände (4) anschließen.

**15.** ICR-Spektrometer nach Anspruch 14, dadurch gekennzeichnet, daß die Ränder der die Trapping-Elektroden (55, 56) bildenden Streifen nicht parallel sind, sondern in ihren Konturen dem Verlauf der Äquipotentiallinien (90) des über die Seitenwände (3) eingestrahlten elektrischen HF-Feldes folgen.

**16.** ICR-Spektrometer nach Anspruch 14 oder 15, dadurch gekennzeichnet, daß die inneren Trapping-Elektroden (56) jeweils an ihre beiden Nachbarn kapazitiv angekoppelt sind, während jede der beiden äußeren Trapping-Elektroden (55) einerseits an die ihr benachbarte innere Trapping-Elektrode (56), andererseits an den der jeweils anderen äußeren Trapping-Elektrode (55) entgegengesetzten Pol der HF-Spannungsquelle (22) kapazitiv angekoppelt ist, wobei sämtliche Trapping-Elektroden (55, 56) ohmsch an einer ein Fangpotential erzeugenden Gleichspannungsquelle (10) angekoppelt sind.

**17.** ICR-Spektrometer nach einem der Ansprüche 7, 8 oder 9, dadurch gekennzeichnet, daß die Meßzelle (1) stirnseitig durch jeweils eine Trapping-Elektrode (85) abgedeckt wird, deren Umfangskonturen (82) dem durch die Kanten (13, 14) der Seitenwände (3, 4) berandeten Querschnitt der Meßzelle (1) entsprechen, wobei jede Trapping-Elektrode (85) an ihrem der Kante (13) einer mit HF beaufschlagten Seitenwand (3) benachbarten Rand (82) kapazitiv an das jeweils an der entsprechenden Seitenwand (3) anliegende HF-Potential angekoppelt ist, und ohmsch an das Fangpotential einer Gleichspannungsquelle (10) angekoppelt ist und wobei der Widerstand einer Trapping-Elektrode (85) zwischen zwei gegenüberliegenden Rändern (82) zwischen 1 und 100 kΩ beträgt.

**18.** ICR-Spektrometer nach einem der Ansprüche 7, 8 oder 9, dadurch gekennzeichnet, daß die Meßzelle (1) stirnseitig durch jeweils eine Trapping-Elektrode (85) abgedeckt wird, deren Umfangskonturen (82) dem durch die Kanten (13, 14) der Seitenwände (3, 4) berandeten Querschnitt der Meßzelle (1) entsprechen, wobei jede Trappping-Elektrode (85) an ihrem der Kante (13) einer mit HF beaufschlagten Seitenwand (3) benachbarten Rand (82) kapazititv an das jeweils an der entsprechenden Seitenwand (3) anliegende HF-Potential angekoppelt ist, und ohmsch an das Fangpotential einer Gleichspannungsquelle (10) angekoppelt ist und wobei die beiden Trapping-Elektroden (85) als Abschlußwiderstände für den HF-Sender dienen und einen Widerstandswert von jeweils 50 Ω aufweisen.

**19.** ICR-Spektrometer nach Anspruch 17 oder 18, dadurch gekennzeichnet, daß die Trapping-Elektroden (85) aus einer hochohmigen Schicht (81) bestehen, die auf der dem Innenraum der Meßzelle (1) zugewandten Fläche einer nicht leitenden Substratschicht (80) aufgebracht ist.

**20.** ICR-Spektrometer nach Anspruch 19, dadurch gekennzeichnet, daß die Substratschicht (80) aus Keramikmaterial, insbesondere $TiO_2$, besteht, und daß die hochohmige Schicht (81) eine aufgedampfte dünne Leiterschicht, insbesondere Ag oder Au, ist.

21. ICR-Spektrometer nach Anspruch 17 oder 18, dadurch gekennzeichnet, daß die Trapping-Elektroden (85) aus einem polymeren halogenierten Polyolefin, insbesondere aus Polytetrafluoräthylen (PTFE), wie z.B. Teflon, bestehen, die einen hohen Kohlenstoffanteil, insbesondere zwischen 10 und 30 Gewichtsprozent, aufweisen.

22. ICR-Spektrometer nach Anspruch 17 oder 18, dadurch gekennzeichnet, daß die Trapping-Elektroden (85) Halbleiter-Materialien, wie z.B. Si, Ge oder GaAs, enthalten.

**Claims**

1. A method of operating an Ion Cyclotron Resonance spectrometer comprising a measuring cell (1) having a plurality of side walls (3,4) designed as rf electrodes and arranged axial symmetrically to an axis (2) extending parallel to the field direction of a homogeneous magnetic field, the measuring cell (1) having electrically insulated trapping electrodes (5,6,35,36,55,56,85) at both axial ends of the measuring cell (1) which can be supplied with trapping potentials of the polarity of the ions under examination in order to prevent, to a large extent, the ions from leaving the measuring cell (1) in the direction of the axis, characterized in that, in order to minimize the component of the electric rf field directed parallel to the axis, which acts upon the ions in the measuring cell (1), additional electric rf signals are each applied to at least one of said trapping electrodes (5,35,55,56,85) on both axial ends of the said measuring cell (1).

2. A method according to claim 1, characterized in that the value of the frequency of the rf signal applied to the said trapping electrodes (5,35,55,56,85) is equal to or an integral multiple of the frequency of the rf signal applied to the side walls (3) next to the respective trapping electrode (5,35,55,56,85).

3. A method according to claim 1 or 2, characterized in that the amplitudes of the rf pulses applied to the said trapping electrodes (5,35,55,56,85) can be adjusted independently of the amplitudes of the rf pulses applied to the said side walls (3).

4. A method according to any of the preceding claims, characterized in that the measuring cell (1) is operated as a drift chamber.

5. A method according to any of the preceding claims, characterized in that the said spectrometer is operated as a double or multiple resonance arrangement.

6. A method according to any of the preceding claims, characterized in that the said spectrometer is operated as a Fourier mass spectrometer.

7. An Ion Cylcotron Resonance (ICR) spectrometer comprising a measuring cell (1) having a plurality of side walls (3, 4) arranged axial symmetrically to an axis (2) extending parallel to the field direction of a homogeneous magnetic field, the side walls connected to an rf generator (22) to function as rf transmitter (3) or as rf receiver electrodes (4), the measuring cell (1) having electrically insulated trapping electrodes (5,6,35,36,55,56,85) at both axial ends of the measuring cell (1), which trapping electrodes (5,6,35,36,55,56,85) can be supplied, via a D.C. voltage source (10), with trapping potentials of the polarity of the ions under examination in order to prevent, to a large extent, the ions from leaving the measuring cell (1) in the direction of the axis, characterized in that additional electric rf signals can each be applied via the rf generator (22) to at least one of said trapping electrodes (5,35,55,56,85) on both axial ends of the said measuring cell (1), whereby the trapping electrodes are fashioned such that the application of the additional rf signals to the trapping electrodes minimizes the component of the electric rf field directed parallel to the axis, which acts upon the ions in the measuring cell (1).

8. An ICR spectrometer according to claim 7, characterized in that the said measuring cell (1) has the shape of a cylinder, in particular of a circular cylinder, a cuboid or a cube, the trapping electrodes (5,6,55,56,85) closing the measuring cell (1) in the axial direction at both ends.

9. An ICR spectrometer according to claim 7 or 8, characterized in that the said side walls (3,4) of the said measuring cell (1) are formed by four nappe sections of a circular cylinder, which are electrically insulated from each other and where two oppositely arranged side walls (3) may be used as rf transmitter electrodes and the other two side walls (4) as rf receiver electrodes.

10. An ICR spectrometer according to claim 9, characterized in that each of the ends of the said measuring cell (1) is closed by a circular disk composed of three trapping electrodes (5,6) and having the radius of the circular cylinder formed by the said side walls (3,4), whereby the outer edges (16) of the inner trapping electrodes (6) face the edges (14) of the side walls (4) which do not have an rf connection, while the outer edges (15) of the two outer trapping electrodes (5) face the edges (13) of the side walls (3) having an rf connection, and the outer trapping electrodes (5) can be supplied with an rf signal in addition to the trapping potential which is applied also to the inner trapping electrodes (6).

11. An ICR spectrometer according to claim 10, characterized in that the said inner (25) and the said outer edges (15) of the said outer trapping electrodes (5) are arcs of a circle of identical arc lengths.

12. An ICR spectrometer according to claim 10, characterized in that the said outer edges (15) of the said outer trapping electrodes (5) and the said outer edges (16) of the said inner trapping electrode (6) are arcs of a circle of identical arc lengths, while the contours of the inner edges (25) of the said outer trapping electrodes (5) and the inner edges (26) of the said inner trapping electrode (6) are approximated to the computed shape of an rf equipotential line (90), in particular the respective equipotential line of half the positive and half the negative amplitude of the rf field applied to the said transmitter electrodes.

13. An ICR spectrometer according to claim 7, characterized in that each of the ends of a cylinder formed by the said side walls (3,4) is followed, in the axial direction, by another cylinder having the same cross-section as the said first cylinder, the azimuthal nappe sections of each of such other cylinders being formed by two pairs of oppositely arranged trapping electrodes (35 or 36) whose edges (45, 46) lie adjacent the edges (13, 14) of the said side walls (3, 4) and have substantially the same length as the latter, and the pair (35) of trapping electrodes which is arranged opposite the rf-carrying side walls (3) of the said measuring cell (1), viewed in axial direction, can carry an rf signal in addition to the trapping potential which is applied also to the other pair (36) of trapping electrodes.

14. An ICR spectrometer according to claim 8 or 9, characterized in that the said measuring cell (1) is closed on each side by a disk whose circumferential contour defines a cross-section corresponding to the cross-section of the measuring cell (1) defined by the side walls (3, 4) perpendicular to the axis (2), the said disk consisting of a plurality of parallel strip-like trapping electrodes (55,56), with one of the longitudinal edges (65) of each said outer trapping electrode (55) being arranged adjacent one side wall (3) of the said measuring cell (1), while the transverse edges (75) are arranged adjacent the edges (14) of the said side walls (4).

15. An ICR spectrometer according to claim 14, characterized in that the contours of the edges of the said strips forming the said trapping electrodes (55, 56), instead of being parallel, follow the actual shape of the equipotential lines (90) of the rf field which is irradiated from said side walls (3).

16. An ICR spectrometer according to claim 14 or 15, characterized in that the said inner trapping electrodes (56) are coupled capacitively to their respective neighbors, while each of the said two outer trapping electrodes (55) is coupled capacitively at one side to its neighboring inner trapping electrode (56) and, at the other side, to the pole of the rf voltage source (22) opposite the other outer trapping electrode (55), all said trapping electrodes (55, 56) being coupled resistively to a D.C. source (10) generating a trapping potential.

17. An ICR spectrometer according to any of claims 7, 8 or 9, characterized in that the said measuring cell (1) is closed on each end by a trapping electrode (85) whose circumferential contours (82) define a cross-section corresponding to the cross-section of the measuring cell (1) defined by the edges (13, 14) of the said side walls (3, 4), each of the said trapping electrodes (85) having its edge (82) neighboring the edge (13) of an rf-carrying side wall (3) coupled on the one hand capacitively to the rf potential applied to the respective side wall (3) and, on the other hand, resistively to the trapping potential of a D.C. source (10), the resistance of a trapping electrode (85) between two opposite edges (82) being in the range of between 1 and 100 kΩ.

18. An ICR spectrometer according to one of the claims 7, 8 or 9, characterized in that the measuring cell (1) is closed on each end by a trapping electrode (85) whose circumferential contours (82) define a cross-section corresponding to the cross-section of the measuring cell (1) defined by the edges (13, 14) of the said side walls (3, 4), each of the said trapping electrodes (85) having its edge (82) neighboring the edge (13) of an rf-impressed side wall (3) coupled on the one hand capacitively to the rf potential applied to the respective side wall (3) and, on the other hand, resistively to the trapping potential of a. D.C. source (10) and the said two trapping electrodes (85) serve as terminating resistors for the said rf transmitter and have a resistance of 50 Ω each.

19. An ICR spectrometer according to claim 17 or 18, characterized in that the said trapping electrodes (85) consist of a high-ohmic coating (81) applied on that face of a non-conductive substrate (80) which faces the interior of the said measuring cell (1).

20. An ICR spectrometer according to claim 19, characterized in that the said substrate (80) consists of a ceramic material, such as $TiO_2$, and the said high-ohmic coating (81) consists of a thin conductive coating, such as Ag or Au, deposited thereon by evaporation.

21. An ICR spectrometer according to claim 17 or 18, characterized in that the said trapping electrodes (85) consist of a polymeric halogenated polyolefine, in particular a poly tetrafluor ethylene (PTFE), such as Teflon, and contain a high proportion of carbon, in particular between 10 and 30 percent by weight.

22. An ICR spectrometer according to claim 17 or 18, characterized in that the said trapping electrodes (85) contain semiconductor materials, such as Si, Ge or GaAs.

## Revendications

1. Procédé pour l'exploitation d'un spectromètre à résonance d'ions en cyclotron, dont la cellule de mesure (1) comprend plusieurs parois latérales (3, 4) configurées en électrodes HF et disposées selon une symétrie axiale par rapport à un axe (2) parallèle à la direction de champ d'un champ magnétique homogène et dont la cellule de mesure (1) présente des électrodes de capture isolées électriquement (5, 6, 35, 36, 55, 56, 85), lesquelles sont placées aux deux extrémités axiales de la cellule de mesure (1), où l'on peut appliquer des potentiels de capture aux bornes des électrodes de capture (5, 6, 35, 36, 55, 56, 85) ayant la polarité des ions que l'on doit étudier, afin d'empêcher, dans une large mesure, la fuite des ions hors de la cellule de mesure (1) dans la direction axiale, caractérisé en ce que, on applique des signaux électriques supplémentaires HF aux bornes d'au moins une électrode de capture (5, 35, 55, 56, 85) suivant le cas afin de minimiser au niveau des deux extrémités axiales de la cellule de mesure (1) la composante parallèle à l'axe du champ électrique HF qui agit sur les ions à l'intérieur de la cellule de mesure (1).

2. Procédé selon la revendication 1, caractérisé en ce que la fréquence du signal HF appliqué aux bornes des électrodes de capture (5, 35, 55, 56, 85) a une valeur qui est identique ou qui est un multiple entier de la fréquence du signal HF appliqué aux bornes des parois latérales (3) des électrodes de capture (5, 35, 55, 56, 85) qui sont situées dans l'espace à proximité immédiate l'une de l'autre.

3. Procédé selon la revendication 1 ou 2, caractérisé en ce que l'on peut faire varier les amplitudes des impulsions HF appliquées aux bornes des électrodes de capture (5, 35, 55, 56, 85) de façon indépendante par rapport aux amplitudes des impulsions HF qui sont appliquées aux bornes des parois latérales (3).

4. Procédé d'après l'une des revendications précédentes caractérisé en ce que, la cellule de mesure (1) est utilisée comme chambre de déviation.

5. Procédé selon l'une des revendications précédentes, caractérisé en ce que le spectromètre est utilisé en tant que système de résonance double ou multiple.

6. Procédé selon l'une des revendications précédentes, caractérisé en ce que le spectromètre est utilisé comme spectromètre de masse de Fourier.

7. Spectromètre à résonance d'ions en cyclotron (ICR), dont la cellule de mesure (1) comporte plusieurs parois latérales (3, 4) configurées comme électrodes émettrices HF (3) reliées à un générateur HF (22) ou le cas échéant, comme électrodes réceptrices HF (4), qui sont disposées en symétrie axiale par rapport à un axe (2) parallèle à la direction de champ d'un champ magnétique homogène et dont la cellule de mesure (1) présente des électrodes de capture isolées électriquement (5, 6, 35, 36, 55, 56, 85), en utilisant une source de courant continu (10), lesquelles sont placées aux deux extrémités axiales de la cellule de mesure (1), où l'on peut appliquer des potentiels de capture aux bornes des électrodes de capture (5, 6, 35, 36, 55, 56, 85) ayant la polarité des ions que l'on doit étudier, afin d'empêcher, dans une large mesure, la fuite des ions hors de la cellule de mesure (1) dans la direction axiale, caractérisé en ce que, on peut appliquer, au moyen du générateur HF (22), des signaux électriques supplémentaires HF aux bornes d'au moins une électrode de capture (5, 35, 55, 56, 85), suivant le cas, afin de minimiser au niveau des deux extrémités axiales de la cellule de mesure (1) la composante parallèle à l'axe du champ électrique HF qui agit sur les ions à l'intérieur de la cellule de mesure (1) où les électrodes de capture sont réalisées selon ce type de configuration.

8. Spectromètre à résonance d'ions en cyclotron (ICR) selon la revendication 7, caractérisé en ce que la cellule de mesure (1) a la forme d'un cylindre, en particulier d'un cylindre circulaire, d'un parallélépipède ou d'un cube et en ce que les électrodes de capture (5, 6, 55, 56, 85) entourent complètement la cellule de mesure (1) aux deux extrémités et dans la direction axiale.

9. Spectromètre à résonance d'ions en cyclotron (ICR) d'après les revendications 7 ou 8, caractérisé en ce que les parois latérales (3, 4) de la cellule de mesure (1) sont constituées de quatre segments enveloppants constituant un cylindre circulaire, isolés électriquement les uns des autres, où deux parois latérales (3) placées l'une en face de l'autre peuvent être utilisées comme électrodes HF émettrices et où les deux autres parois latérales (4) peuvent être utilisées comme électrodes HF réceptrices.

10. Spectromètre à résonance d'ions en cyclotron (ICR) selon la revendication 9, caractérisé en ce que la cellule de mesure (1) est recouverte respectivement sur ses côtés avants par une plaque circulaire dont le rayon est celui du cylindre circulaire formé par les parois latérales (3, 4), lequel se compose respectivement de trois électrodes de capture (5, 6), où les bords extérieurs (16) des électrodes de capture internes (6) sont placées en face des bords (14) des parois latérales (4) sans qu'il y ait raccordement HF, où les bords extérieurs (15) des deux électrodes de capture externes (5) sont placés en face des bords (13) des parois latérales (3) avec raccordement HF, et où les électrodes de capture extérieures (5) peuvent encore recevoir un signal HF en supplément du potentiel de capture qui est également présent au niveau des électrodes de capture intérieures (6).

11. Spectromètre à résonance d'ions en cyclotron (ICR) selon la revendication 10, caractérisé en ce que les bords extérieurs (15) et les bords intérieurs (25) présentent des longueurs d'arc identiques à celles des arcs de cercle constitués par les électrodes de capture extérieures (5).

12. Spectromètre à résonance d'ions en cyclotron (ICR) selon la revendication 10, caractérisé en ce que les bords extérieurs (15) des électrodes de capture extérieures (5) et les bords extérieurs (16) de l'électrode de capture intérieure (6) présentent des arcs de cercle dont la longueur d'arc est identique, tandis que les contours des bords intérieurs (25) des électrodes de capture extérieures (5) et les bords intérieurs (26) de l'électrode de capture intérieure (6) se rapprochent du tracé obtenu par calcul, d'une ligne équipotentielle HF (90), en particulier de la ligne équipotentielle qui correspond respectivement à la demi amplitude positive et la demi amplitude négative du champ HF appliqué au niveau des électrodes émettrices.

13. Spectromètre à résonance d'ions en cyclotron (ICR) selon la revendication 7, caractérisé en ce qu'un autre cylindre de section identique à celle des premiers cylindres se raccorde de part et d'autre, dans la direction de l'axe, selon le cas, à un cylindre qui est constitué par les parois latérales (3, 4), dont les segments azimutaux de type enveloppant sont constitués respectivement par deux paires d'électrodes de capture (35 ou 36) placées en opposition, où les bords (45, 46) des électrodes de capture (35, 36) se raccordent aux bords (13, 14) des parois latérales (3, 4) et possèdent à peu près la même longueur que ces derniers et où l'on peut appliquer aux bornes de ladite paire (35) d'électrodes de capture qui, vues dans la direction de l'axe, sont placées en face des parois latérales (3) de la cellule de mesure (1) aux bornes desquelles on a appliqué un signal haute fréquence, en supplément du potentiel de capture également appliqué à l'autre paire d'électrodes de capture (36).

14. Spectromètre à résonance d'ions en cyclotron (ICR) d'après les revendications 8 ou 9, caractérisé en ce que la cellule de mesure (1) est recouverte respectivement de chaque côté par une plaque, dont le contour extérieur limite une section qui correspond, perpendiculairement à l'axe (2), à la section de la cellule de mesure (1), laquelle est constituée par les parois latérales (3, 4), où la plaque est constituée par un certain nombre d'électrodes de capture (55, 56) en forme de lames, placées en parallèle, dont les électrodes de capture extérieures (55) se raccordent respectivement par leurs bords longitudinaux (65) aux bords respectifs (13) d'une des parois latérales (3) de la cellule de mesure (1), tandis que les bords transversaux (75) se raccordent aux bords (14) des parois latérales (4).

15. Spectromètre à résonance d'ions en cyclotron (ICR) selon la revendication 14, caractérisé en ce que les bords des lames qui constituent les électrodes de capture (55, 56) ne sont pas parallèles, mais suivent dans leur contour le tracé des lignes équipotentielles (90) du champ électrique HF rayonné au-delà des parois latérales (3).

16. Spectromètre à résonance d'ions en cyclotron (ICR) selon les revendications 14 ou 15, caractérisé en ce que les électrodes de capture intérieures (56) sont respectivement accouplées par l'intermédiaire de capacités à leurs deux voisines, tandis que chacune des deux électrodes de capture extérieures (55) est couplée par l'intermédiaire de capacités, d'une part à l'électrode de capture intérieure (56) qui lui est immédiatement adjacente et d'autre part au pôle opposé de l'autre électrode de capture extérieure (55) de la source de tension HF (22), où les résistances de l'ensemble des électrodes de capture (55), 56) sont respectivement couplées à une source de tension continue (10) qui produit un potentiel de capture.

17. Spectromètre à résonance d'ions en cyclotron (ICR) selon l'une des revendications 7, 8 ou 9, caractérisé en ce que la cellule de mesure (1) est recouverte à l'avant par, respectivement, une électrode de capture (85) dont les contours extérieurs (82) correspondent à la section délimitée par les bords (13, 14) des parois latérales (3, 4), de la cellule de mesure (1), où chaque électrode de capture (85) est couplée par l'intermédiaire d'une capacité, au niveau du bord (82) immédiatement adjacent, au bord (13) d'une paroi latérale (3) aux bornes de laquelle on applique un signal haute fréquence, au potentiel HF appliqué aux bornes de la paroi respectivement correspondante (3), et où la résistance de chaque électrode de capture (85) est couplée au potentiel de capture d'une source de tension continue (10) et où la résistance d'une électrode de capture (85) vaut de 1 à 100 kΩ entre les deux bords placés l'un en face de l'autre (82).

18. Spectromètre à résonance d'ions en cyclotron (ICR) selon l'une des revendications 7, 8 ou 9, caractérisé en ce que la cellule de mesure (1) est recouverte à l'avant par, respectivement, une électrode de capture (85) dont les contours extérieurs (82) correspondent à la section délimitée par les bords (13, 14) des parois latérales (3, 4), de la cellule de mesure (1), où chaque électrode de capture (85) est couplée par l'intermédiaire d'une capacité, au niveau du bord (82) immédiatement adjacent, au bord (13) d'une paroi latérale (3) aux bornes de laquelle on applique un signal haute fréquence, au potentiel HF appliqué aux bornes de la paroi respectivement correspondante (3), et où la résistance de chaque électrode de capture (85) est couplée au potentiel de capture d'une source de tension continue (10) et où la résistance d'une électrode de capture (85) vaut de 1 à 100 kΩ entre les deux bords placés l'un en face de l'autre (82) et ou les deux électrodes de capture (85) sont utilisées en tant que résistance de protection pour l'émetteur HF et possèdent respectivement une valeur de résistance de 50 Ω.

19. Spectromètre à résonance d'ions en cyclotron (ICR) selon les revendications 17 ou 18, caractérisé en ce que les électrodes de capture (85) sont constituées par une couche de valeur ohmique élevée, qui est déposée sur la surface orientée vers l'intérieur de la cellule de mesure (1), laquelle est constituée d'une couche de support non conductrice (80).

20. Spectromètre à résonance d'ions en cyclotron (ICR) selon la revendication 19, caractérisé en ce que la couche de substrat (80) est constituée d'un matériau céramique, en particulier, par le $TiO_2$, et en ce que la couche de valeur ohmique élevée (80) est constituée d'une fine couche conductrice déposée par un procédé de déposition en phase vapeur, constitué en particulier d'Ag ou d'Au.

21. Spectromètre à résonance d'ions en cyclotron (ICR) selon les revendications 17 ou 18, caractérisé en ce que les électrodes de capture (85) sont constituées par une polyoléfine halogénée polymérisée, en particulier, par un polytétrafluoroéthylène (PTFE) polymérisé tel que, par exemple, le Téflon, qui possèdent une teneur en carbone élevée, en particulier, de 10 à 30 % en poids.

22. Spectromètre à résonance d'ions en cyclotron (ICR) selon les revendications 17 ou 18, caractérisé en ce que les électrodes de capture (85) contiennent des matériaux semi-conducteurs tels que, par exemple, le Si, le Ge ou GaAs.

Fig. 1a

Fig. 1b

Fig. 2

Fig. 3a

Fig. 3b

Fig. 3c

Fig. 4

Fig. 5 a

Fig. 5 b